Europäisches Patentamt

European Patent Office

Office européen des brevets

(11) Publication number: **0 180 989**

**B1**

(12) **EUROPEAN PATENT SPECIFICATION**

(45) Date of publication of patent specification: **25.07.90**

(51) Int. Cl.⁵: **H 03 H 17/06**

(21) Application number: **85114190.3**

(22) Date of filing: **07.11.85**

(54) **Rate conversion digital filter.**

(30) Priority: **08.11.84 JP 235409/84**

(43) Date of publication of application:
**14.05.86 Bulletin 86/20**

(45) Publication of the grant of the patent:
**25.07.90 Bulletin 90/30**

(84) Designated Contracting States:
**DE FR GB NL**

(56) References cited:
**WO-A-84/05001**

**PROCEEDINGS OF THE IEEE INTERNATIONAL
CONFERENCE ON ACOUSTICS, SPEECH AND
SIGNAL PROCESSING, Boston, Masschusetts,
US; 14th-16th April 1983, vol. 1 or 3, pages
427-430, IEEE, New York, US; N. ROETHE:
"Architecture and programming of a multirate
digital filter"**

(73) Proprietor: **NEC CORPORATION**
**7-1, Shiba 5-chome Minato-ku**
**Tokyo 108-01 (JP)**

(72) Inventor: **Hirosaki, Botaro**
**c/o NEC Corporation 33-1, Shiba -5chome**
**Minato-ku Tokyo (JP)**

(74) Representative: **Vossius & Partner**
**Siebertstrasse 4 P.O. Box 86 07 67**
**D-8000 München 86 (DE)**

(56) References cited:
**A.E.Ü., vol. 25, no. 3, 1971, pages 155-159,
Stuttgart, DE; P. LEUTHOLD: "Transversalfilter
zur Erzeugung von Funktionspaaren, die durch
die Hilbert-Transformation verknüpft sind"**

**PATENTS ABSTRACTS OF JAPAN, vol. 4, no. 28
(E-1)510r, 8th March 1980; & JP - A - 55 660
(FUJITSU K.K.) 07-01-1980**

Courier Press, Leamington Spa, England.

## Description

### Background of the invention

The present invention relates to a rate conversion digital filter in which the sampling rate of the input digital signal is reduced by a factor of 1/2.

Sampling rate reduction techniques are used for interfacing different types of digital communications media which proliferate at an increasing rate in various fields of application. In digital audio techniques, for example, original analog signals are sampled at a predetermined sampling frequency fs and quantized into a digital stream of 16-bit words. If the original signal has a bandwidth exceeding the fs/2 limit, foldover distortion, or "aliasing" occurs. For this purpose the analog signal is passed through a low-pass filter having a cut-off frequency of fs/2 before it is sampled. Since audio recording requires a distortion factor as high as 70 to 80 dB, the roll-off characteristic of the filter must be as sharp as possible and group delays resulting from such filter characteristic must be equalized. However, if the original analog signal is sampled at twice the predetermined rate fs, the low-pass filtering process can be realized by a digital filter having a sharp roll-off characteristic with no attendant group delays. Taking every other samples from the sampled audio signal results in a signal having the desired sampling rate fs.

Various attempts have hitherto been made to implement rate reduction digital filters. If finite impulse response (FIR) digital filters having an N-th filter order are employed, computations can be reduced to N/2 by a 1/2 rate reduction if the order of such filters is N−1. If FIR digital filters having symmetrical coefficients are used, a very efficient signal processing circuitry can be implemented with N/4 computations. However, if two channel signals are multiplexed using rate conversion FIR digital filters, two registers must be provided respectively for the different channels while only one set of tap coefficients is required. This results in complex circuitry.

The post published WO—A—84 05001 which matured into EP—A—0146601 describes a down sampling and prefilter device feeding signal samples from two signal streams in parallel to a switching network and subsequently the samples from the two signal streams alternately to one or the other of two phases of filters.

The present invention is to provide a sampling rate reduction digital filter which eliminates the disadvantage of the prior art and has for its object to a technique whereby two-channel multiplexing and 1/2 sample rate reduction are coupled with a high degree of efficiency.

### Summary of the invention

It is therefore an object of the invention to provide a rate conversion digital filte having a simplified structure. This object is solved with the features of claim 1.

### Brief description of the drawings

The present invention will be described in further detail with reference to the accompanying drawings, in which:

Fig. 1 is a block diagram useful for describing the underlying principle of the present invention;

Fig. 2 is a block diagram of a specific embodiment of a sampling rate reduction digital filter constructed according to the present invention; and

Fig. 3 is a block diagram of a simplified version of the embodiment of Fig. 1 in the case of the presence of symmetricity between coefficients.

### Detailed description

Before going into detail of the present invention, the underlying principle of the present invention will first be described. Assume that the sampling frequency of the input digital data stream is 1/T and $\exp\{-j\omega T\}$ is represented by Z according to the Z-conversion notation so that two input digital streams are represented by $X_1(z)$ and $X_2(z)$, respectively, rate reduction operation can be achieved by passing $X_1(z)$ and $X_2(z)$ respectively through digital filters H(z) having a cut-off frequency 1/4T and sampling every other digital samples from each of the outputs of the digital filters. Let $[A(z)]_E$ and $[A(z)]_O$ represent respectively the process involved in sampling the even-numbered samples and the odd-numbered samples of a digital data stream A(z), the output data stream Y(z) which is obtained by multiplexing the two rate-reduced data streams is given by:

$$Y(z)=[X_1(z)H(z)]_E+[X_2(z)H(z)]_O \tag{1}$$

If the digital filter H(z) is a finite impulse response (FIR) digital filter of the (N−1)th order, and if H(z) is reduced as follows:

$$H(z)=a_0+a_1z^{-1}+a_2z^{-2}+\ldots+a_{N-1}z^{-(N-1)} \tag{2}$$

H(z) can be divided into the following two subfilters:

$$H(z)=H_1(z^2)+z^{-1}H_2(z^2) \tag{3}$$

2

where

$$H_1(z^2)=a_0+a_2z^{-2}+\ldots+a_{N-2}z^{-(N-2)} \qquad (4)$$

$$H_2(z^2)=a_1+a_3z^{-2}+\ldots+a_{N-1}z^{-(N-2)} \qquad (5)$$

From Equations 1 and 3, the multiplexed output $Y(z)$ is given by:

$$Y(z)=([X_1(z)]_E+[X_2(z)]_O)H_1(z^2)+([X_2(z)]_E+[X_1(z)]_O)z^{-1}H_2(z^2) \qquad (6)$$

If $H_1(z^2)$ and $H_2(z^2)$ given by Equations 4 and 5 are represented respectively by:

$$H_1(z^2)=a_0+z^{-2}H_{11}(z^2)$$

$$H_2(z^2)=a_1+z^{-2}H_{21}(z^2)$$

then Equation 6 can be written as:

$$Y(z)=S_1(z)[a_0+z^{-2}H_{11}(z^2)]+S_2(z)z^{-1}[a_1+z^{-2}H_{21}(z^2)]$$

$$=S_1(z)a_0+S_1(z)z^{-2}H_{11}(z^2)+S_2(z)z^{-1}a_1+S_2(z)z^{-3}H_{21}(z^2) \qquad (7)$$

where,

$$S_1(z)=[X_1(z)]_E+[X_2(z)]_O$$

$$S_2(z)=[X_2(z)]_E+[X_1(z)]_O$$

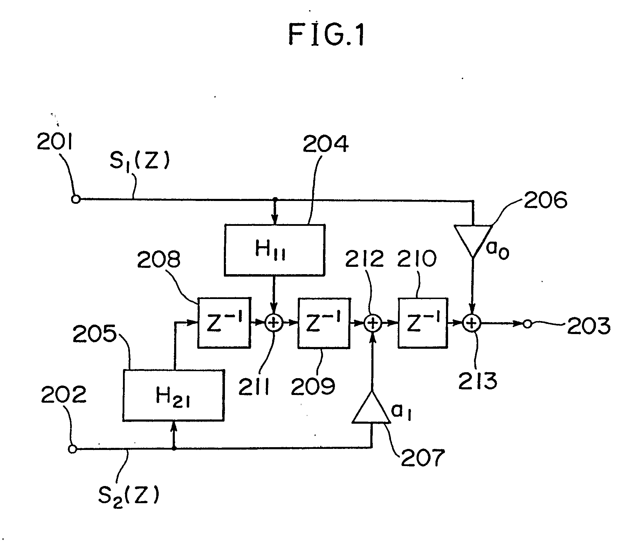

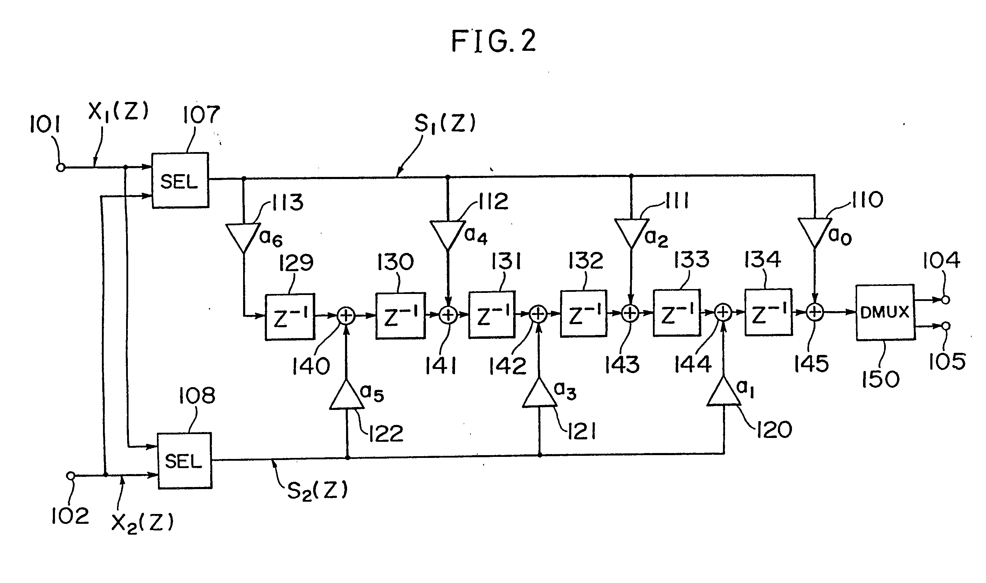

Equation 7 can be realized by a block-diagram shown in Fig. 1. A digital input signal $S_1(z)$ is applied through a terminal 201 to a digital filter 204 having a filter function $H_{11}(z_2)$ and to a multiplier 206 having a multiplying factor $a_0$ and a digital input signal $S_2(z)$ is applied through a terminal 202 to a digital filter 205 having a filter function $H_{21}(z^2)$ and to a multiplier 207 having a multiplying factor $a_1$. Indicated at 208, 209 and 210 are registers each having a unit delay time T. The output of filter 205 is delayed by shift register 208 and summed with the output of filter 204 in an adder 211. The output of adder 211 is delayed by shift register 209 and summed with the output of multiplier 207 in an adder 212. The output of adder 212 is delayed by shift register 210 and summed with the output of multiplier 206 and supplied to an output terminal 203. By expanding the digital filter functions $H_{11}(z^2)$ and $H_{21}(z^2)$, a specific embodiment of the rate conversion digital filter can be realized as shown in Fig. 2.

For purposes of simpliicity, a digital filter of the sixth order (N=7) is illustrated. In Fig. 2, first and second data streams of digital samples $X_1(z)$ and $X_2(z)$ having a sampling frequency 1/T are applied to input terminals 101 and 102, respectively. A first multiplexer, or selector 107 multiplexes the even-numbered digital samples of the first sample series $X_1(z)$ and the odd-numbered digital samples of the second sample series $X_2(z)$ and supplies a multiplexed digital sample series $S_1(z)$ to multipliers 110, 111, 112 and 113 having multiplying factors $a_0$, $a_2$, $a_4$ and $a_6$, respectively. A second selector 108 multiplexes the odd-numbered digital samples of the first sample series $X_1(z)$ and the even-numbered digital samples of the second sample series $X_2(z)$ in a complementary manner to the selector 107 and supplies a multiplexed digital sample series $S_2(z)$ to multipliers 120, 121 and 122 having multiplying factors $a_1$, $a_3$ and $a_5$, respectively. Shift registers 129—134 are provided each being clocked at frequency 1/T to introduce a unit delay time T. The output of each register is connected to each one of adders 140—145 and the output of each of adders 140—144 is connected to the input of register of the following stage.

The rate conversion digital filter of the invention is thus formed by first and second subfilters respectively responsive to the outputs of the selectors 107 and 108. Shift registers 129—134 and adders 140—145 form a register-and-adder network shared in common by the first and second subfilters through the respective multipliers. The shared use of the common register-adder network results in a simplified rate conversion digital filter.

In operation, a digital sample $S_1(z)$ from selector 107 is multiplied by $a_6$ by multiplier 113 and delayed by an interval T by register 129 and multiplexed with a digital sample $S_2(z)a_5$ from multiplier 122 by adder 140 and further delayed by interval T by register 130 and multiplexed by adder 141 with a digital sample $S_1(z)a_4$ from multiplier 112. The output of adder 141 is delayed by register 131 and multiplexed by adder 142 with a digital sample $S_2(z)a_3$ from multiplier 121. The output of adder 142 is delayed by register 132, multiplexed with a sample $S_1(z)a_2$ from multiplier 111, delayed further by register 133, multiplexed by adder 144 with a digital sample $S_2(z)a_1$ from multiplier 120, delayed by register 134 and multiplexed by adder 145 with a digital sample $S_1(z)a_0$ from multiplier 110. The output of adder 145 is a series of digital samples represented by

$$S_1(z)a_0+z^{-1}S_2a_1+z^{-2}S_1(z)a_2+z^{-3}S_2(z)a_3+z^{-4}S_1(z)a_4+z^{-5}S_2(z)a_5+z^{-6}S_1(z)a0417Kf38_6.$$

A demultiplexer 150 extracts samples $X_1(z)$ from the output series at twice the sampling interval T and

EP 0 180 989 B1

supplies a series of even-numbered samples $[X_1(z)Hz]_E$ to an output terminal 104 and extracts samples $X_2(z)$ at twice the sampling interval T and supplies a series of odd-numbered samples $[X_2(z)Hz)]_O$ to an output terminal 105.

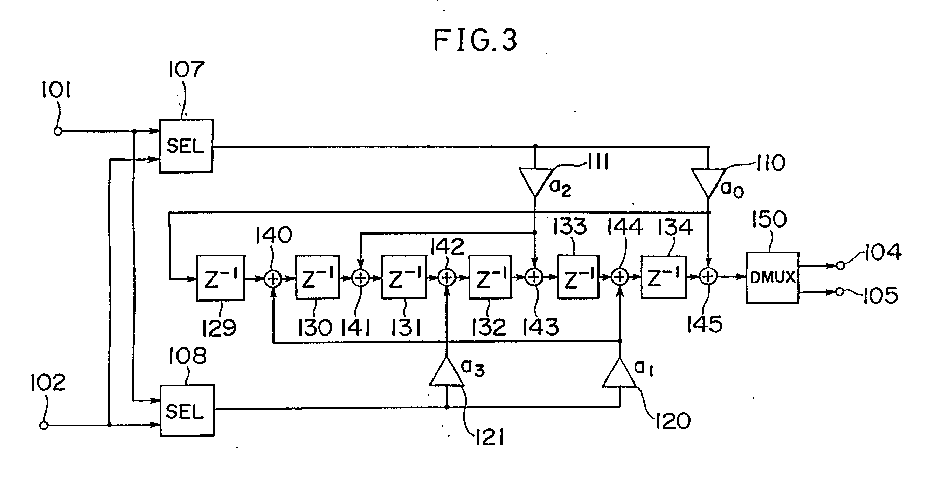

If the subfilters have a linear relation between phase and frequency, a digital filter having no delay distortion can be realized. Such digital filters can be realized if the filter order is even since it can be shown that each of the subfilters $H_1$ and $H_2$ of Equation 3 has symmetrical coefficients. Under such conditions, relations $a_0=a_6$, $a_2=a_4$, $a_1=a_5$ hold and multipliers 112, 113 and 122 can be dispensed with as shown in Fig. 3. In Fig. 3, the adders 140 and 141 take their inputs from the outputs of multipliers 120 and 111, respectively, and register 129 takes its input from the output of multiplier 110.

## Claims

1. A finite impulse response digital filter responsive to first and second digital data streams each being sampled at intervals T, comprising a first multiplexer (107) for alternately multiplexing samples of said first and second data streams at intervals T, a second multiplexer (108) for alternately multiplexing samples of said first and second data streams at intervals T in a manner complementary to said first multiplexer (107), a plurality of storage means (129—134) arranged in successive stages and simultaneously clocked at intervals T for introducing a unit delay time T in each of said storage means, first multiplier means (110—113) for multiplying the output signal of said first multiplexer (107) by first multiplying factors ($a_0$, $a_2$, $a_4$, $a_6$) and generating a plurality of first multiplied samples, second multiplier means (120—122) for multiplying the output signal of said second multiplexer (108) by second multiplying factors ($a_1$, $a_3$, $a_5$) and generating a plurality of second multiplied samples, and a plurality of summation means (140—145) respectively connected between successive ones of said storage means for respectively providing summation of said first multiplied samples with outputs of alternate ones of said storage means and respectively providing summation of said second multiplied samples with outputs of the other storage means, characterized in that each of said first and second multiplier means (110—113, 120—122) comprises an equal number of multipliers, and a total number of said multipliers of said first and second multiplier means is smaller than a total number of said storage means, and in that each output of the multipliers of said first multiplier means is connected to one or more of the alternate ones (141, 143, 145) of said summation means and each output of the multipliers of said second multiplier means is connected to one or more of the others (142, 144) of said summation means such that an odd number of said first and second multiplying factors ($a_0$, $a_0$, $a_2$, $a_2$, $a_1$, $a_1$, $a_3$) are provided for establishing a symmetrical value relationship with respect to one of said first and second multiplying factors.

2. A finite impulse response digital filter as claimed in claim 1, characterized in that a demultiplexer is provided to separate the summation of multiplied samples of each digital data stream from the summation of multiplied samples of the other digital data stream.

## Patentansprüche

1. Auf einen begrenzten Impuls ansprechender digitaler Filter, der auf erste und zweite digitale Datenströme anspricht, die in Intervallen T abgetastet werden, mit einem ersten Multiplexer (107), um die Tastwerte des ersten und zweiten Datenstroms in Intervall T alternierend zu multiplexen, einem zweiten Multiplexer (108), um die Tastwerte des ersten und zweiten Datenstroms im Interval T komplementär zum ersten Multiplexer (107) altenierend zu multiplexen, mehreren speichereinrichtungen (129—134), die in aufeinanderfolgenden Stufen angeordnet sind und in den Intervallen T gleichzeitig zugeschaltet werden, um eine einheitliche Verzögerungszeit T in jeder Speichereinrichtung einzuführen, ersten Verveilfachungseinrichtungen (110—113), um das Ausgangssignal des ersten Multiplexers (107) mit ersten Multiplikatoren ($a_0$, $a_2$, $a_4$, $a_6$) zu multiplizieren und mehrere erste vervielfachte Abtastwerte zu erzeugen, zweiten Verveilfachungseinrichtungen (120—122), um das Ausgangsignal des zweiten Multiplexers (108) mit zweiten Multiplikatoren ($a_1$, $a_3$, $a_5$) zu multiplizieren und mehrere zweite verveilfachte Abtastwerte zu erzeugen, und mehreren Summierungseinrichtungen (140—145), die entsprechend zwischen aufeinanderfolgende Speichereinrichtungen geschaltet sind, um die ersten vervielfachten Abtastwerte mit den Ausgängen von alternierenden Speichereinheiten und die zweiten vervielfachten Abtastwerte mit den Ausgängen der anderen Speichereinrichtungen entsprechend zu summieren, dadurch gekennzeichnet, daß jede der ersten und zweiten Vervielfachungseinrichtungen (110—113, 120—123) eine gleiche Anzahl von Vervielfachern aufweist, und eine Gesamtzahl der Vervielfacher der ersten und zweiten Vervielfachungseinrichtungen kleiner als eine Gesamtzahl der Speichereinrichtungen ist, und daß jeder Ausgang der Vervielfacher der ersten Vervielfachungseinrichtung mit einer oder mehreren der alternierenden Summierungseinrichtungen (141, 143, 145) verbunden ist und jeder Ausgang der Verveilfacher der zweiten Vervielfachungseinrichtung mit einer oder mehreren der anderen Summierungseinrichtungen (142, 144) verbunden ist, so daß eine ungerade Zahl der ersten und zweiten Multiplikatoren ($a_0$, $a_0$, $a_2$, $a_2$, $a_1$, $a_1$, $a_3$) zur Verfügung gestellt wird, um eine symmetrische Wertebeziehung mit Bezug auf einen der ersten und zweiten Multiplikatoren herzustellen.

2. Auf einen begrenzten Impuls ansprechender Digitalfilter nach Anspruch 1, dadurch gekennzeichnet, daß ein Demultiplexer vorgesehen ist, um die Summierung der vervielfachten Abtastwerte jedes digitalen

## EP 0 180 989 B1

Datenstroms von der Summierung der vervielfachten Abtastwerte des anderen digitalen Datenstrom zu separieren.

### Revendications

1. Filtre numérique à réponse impulsionnelle finie répondant à des premier et second trains de données numériques, échantillonnés chacun à des intervalles T, comprenant un premier multiplexeur (107) pour alternativement multiplexer des échantillons des premier et second trains de données à des intervalles T, un second multiplexeur (108) pour alternativement multiplexer des échantillons des premier et second trains de données à des intervalles T dans une manière complémentaire au premier multiplexeur (107), une multitude de moyens de stockage (129—134) disposés dans des étages successifs et rythmés simultanément à des intervalles T pour introduire un retard unitaire T dans chacun des moyens de stockage, des premiers moyens de multiplicateur (110—113) pour multiplier le signal de sortie du premier multiplexeur (107) par des premiers facteurs de multiplication ($a_0$, $a_2$, $a_4$, $a_6$) et produire une multitude de premiers échantillons multipliés, des seconds moyens de multiplicateur (120—122) pour multiplier le signal de sortie de second multiplexeur (108) par des seconds facteurs de multiplication ($a_1$, $a_3$, $a_5$) et produire une multitude de seconds échantillons multipliés, et une multitude de moyens de sommation (140—145) connectés respectivement entre des moyens successifs parmi les moyens de stockage pour fournir respectivement la sommation des premiers échantillons multipliés avec les sorties de moyens alternés parmi les moyens de stockage et fournir respectivement la sommation des seconds échantillons multpliés avec les sorties des autres moyens de stockage, caractérisé en ce que chacun des premiers et seconds moyens de multiplicateur (110—113, 120—122) comprend un nombre égal de multiplicateurs, et un nombre total de multiplicateurs des premiers et seconds moyens de multiplicateurs est inférieur au nombre total des moyens de stockage, et en ce que chaque sortie des multiplicateurs des premiers moyens de multiplicateur est connectée à un ou plusieurs des moyens alternés (141, 143, 145) parmi les moyens de sommation et chaque sortie des multiplicateurs des seconds moyens de multiplicateur est connectée à un ou plusieurs des autres moyens (142, 144) parmi les moyens de sommation de sorte qu'un nombre impair des premier et second facteurs de multiplication ($a_0$, $a_0$, $a_2$, $a_2$, $a_1$, $a_1$, $a_3$) est fourni pour établir une relation de valeurs symétriques par rapport à l'un des premier et second facteurs de multiplication.

2. Filtre numérique à réponse impulsionnelle finie selon la revendication 1, caractérisé en ce qu'un démultiplexeur est prévu pour séparer la sommation des échantillons multipliés de chaque train de données numériques à partir de la sommation d'échantillons multipliés de l'autre train de données numériques.

5

# FIG.1

## FIG.2

# FIG.3

EP 0 180 989 B1